# FASCICULE DE BREVET EUROPEEN

(11) **EP 2 960 940 B1**
(45) Date de publication et mention de la délivrance du brevet: **22.03.2017**
(21) Numéro de dépôt: 15173564.4
(22) Date de dépôt: 24.06.2015
(51) Int. Cl.: H01L 27/15, H01L 31/02, H01L 33/38, H01L 31/0224, H01L 27/146, H01L 27/144, H01L 31/0352, H01L 31/18, H01L 33/62, H01L 33/20

(54) **DIODE DE STRUCTURE MESA A SURFACE DE CONTACT SENSIBLEMENT PLANE**
DIODE MIT MESASTRUKTUR UND IM WESENTLICHEN EBENER KONTAKTFLÄCHE
MESA DIODE WITH SUBSTANTIALLY PLANAR CONTACT SURFACE

(30) Priorité: 27.06.2014 FR 1456085
(43) Date de publication de la demande: 30.12.2015
(73) Titulaire: Commissariat à l'Énergie Atomique et aux Énergies Alternatives, 75015 Paris (FR)
(72) Inventeur: Bono, Hubert, 38000 Grenoble (FR); Robin, Ivan-Christophe, 38000 Grenoble (FR)
(74) Mandataire: Brevalex

(56) Documents cités:
- FR-A1- 2 992 465
- US-A- 5 952 681
- US-A1- 2014 159 063

## Description

### DOMAINE TECHNIQUE ET ART ANTÉRIEUR

L'invention concerne le domaine des diodes, avantageusement celui des diodes photo-émettrices telles que des diodes électroluminescentes (DELs, ou LEDs ou micro-LEDs) et celui des dispositifs, tels que des luminaires ou des dispositifs d'éclairage, comportant des LEDs : ampoules LEDs, éclairages LEDs, dispositifs de signalisation, projecteurs LEDs, éclairages intelligents, etc. L'invention s'applique également au domaine des diodes photo-réceptrices telles que des photodiodes et celui des dispositifs, tels que des dispositifs de détection ou des capteurs, comportant des photodiodes.

Un dispositif d'éclairage à LEDs, tel qu'une ampoule LEDs, utilise généralement un dispositif d'alimentation électrique, appelé driver, adaptant une tension initiale, par exemple la tension du secteur, à la tension de fonctionnement du dispositif d'éclairage. Une telle adaptation est nécessaire du fait que la tension de fonctionnement d'une LED est généralement de quelques volts, par exemple environ 3V, alors que la tension crête du secteur est par exemple de 320V dans le cas d'une alimentation par une tension alternative de 230V.

Or, ces drivers sont à l'origine de plus de la moitié des causes de défaillance des dispositifs d'éclairage à LEDs. De plus, un autre problème qui va à l'encontre d'un fonctionnement des LEDs avec une forte densité de courant est le management thermique et l'évacuation de la chaleur générée par le fonctionnement des LEDs qui doivent être réalisés dans ce cas.

La mise en série des LEDs au sein du dispositif d'éclairage permet d'obtenir une tension de fonctionnement, pour cet ensemble de LEDs reliées en série, plus importante que la tension de fonctionnement d'une LED unitaire du fait que la tension de fonctionnement de cet ensemble de LEDs est égale à la somme des tensions de fonctionnement unitaires de ces LEDs. En augmentant la valeur de la tension de fonctionnement du dispositif d'éclairage, la fiabilité du driver utilisé est améliorée du fait que l'architecture d'un tel driver ne nécessite pas de faire appel à des capacités et des convertisseurs d'aussi grandes valeurs que lorsque le dispositif présente une tension de fonctionnement égale à celle d'une seule LED.

Pour réaliser la mise en série des LEDs, ou plus généralement les interconnexions électriques de plusieurs LEDs, les technologies proposées sont basées sur des procédés standards utilisés communément en technologie dite planaire : chaque brique de base est définie par une étape de dépôt, puis une étape de lithographie, suivie d'une étape de gravure. Ainsi, avec ce type de procédé, chaque motif d'un matériau nécessite la mise en oeuvre de trois étapes. De plus, chaque motif réalisé doit être aligné avec les précédents. Moyennant cela, la définition du motif doit prendre en compte les performances des équipements concernés tant en termes de dimensions atteignables que de performances d'alignement par rapport au motif précédent. Il en résulte une perte conséquente de surface émissive.

Par exemple, le document US 6,957,899 B2 décrit la mise en série de LEDs via la réalisation de connexions électriques par dépôt, lithographie et gravure. Les problèmes exposés précédemment se retrouvent donc lors de la réalisation des connexions électriques. De plus, dans ce type de structure, la réalisation de l'isolation électrique entre les électrodes des LEDs via la réalisation de couches d'isolation déposées conformément aux motifs de la structure engendre une perte importante de la surface active disponible par rapport à la surface totale disponible.

Les documents US 7,221,044 B2 et US 8,272,757 B1 décrivent la mise en série de LEDs via une hybridation des LEDs sur un substrat sur lequel sont réalisées des interconnexions électriques, l'hybridation étant réalisée via des microbilles fusibles. Une telle hybridation est difficile à mettre en oeuvre du fait de la structure irrégulière des LEDs. De plus, l'interconnexion électrique des LEDs via un substrat sur lequel les LEDs sont hybridées par des microbilles a également pour inconvénient d'augmenter la valeur de la résistance électrique série de l'ensemble, et donc de générer des pertes électriques dues au transport des charges à travers le substrat et les microbilles.

Dans le document US 2013/0105825 A1, les liaisons électriques entre les LEDs sont réalisées par des fils ou des éléments de connexion réalisés sur les LEDs. Les techniques mises en oeuvre dans ce document pour réaliser ces fils ou éléments de connexion sont toutefois délicates à mettre en oeuvre et difficilement applicables pour une mise en oeuvre industrielle.

Les documents FR 2992465A1 et US 5952681 décrivent des procédés et dispositifs connus de l'art antérieur.

### EXPOSÉ DE L'INVENTION

Un but de la présente invention est de proposer une diode dont l'architecture facilite sa connexion électrique, notamment lors d'une mise en série de celle-ci avec d'autres diodes d'architecture semblable, qui soit adaptée pour être intégrée avec une forte densité avec d'autres diodes semblables au sein d'un dispositif électronique, facilitant une éventuelle hybridation sur celle-ci, évitant la réalisation de fils ou d'éléments connexion tels que dans l'art antérieur, et garantissant une bonne isolation électrique entre les électrodes de la diode.

Pour cela, il est proposé une diode, ou micro-diode, de structure mesa comportant au moins :
- une première et une deuxième portions de semi-conducteur dopées formant une jonction p-n et telles qu'une première partie de la deuxième portion de semi-conducteur dopée disposée entre une deuxième partie de la deuxième portion de semi-conducteur dopée et la première portion de semi-conducteur dopée forme un décrochement, ou renfoncement, par rapport à la deuxième partie de la deuxième portion de semi-conducteur dopée,
- une première électrode reliée électriquement à la première portion de semi-conducteur dopée, et une deuxième électrode reliée électriquement à la deuxième portion de semi-conducteur dopée au niveau d'une face supérieure de la deuxième partie de la deuxième portion de semi-conducteur dopée,
- des portions diélectriques recouvrant des flancs latéraux de la première portion de semi-conducteur dopée, de la deuxième portion de semi-conducteur dopée et de la première électrode,
et dans lequel des faces supérieures de la première électrode, de la deuxième électrode et des portions diélectriques forment une surface continue sensiblement plane.

En outre, l'invention propose un dispositif électronique ou microélectronique comprenant au moins deux diodes de structure mesa, chaque diode comportant au moins :
- une première et une deuxième portions de semi-conducteur dopées formant une jonction p-n et telles qu'une première partie de la deuxième portion de semi-conducteur dopée disposée entre une deuxième partie de la deuxième portion de semi-conducteur dopée et la première portion de semi-conducteur dopée forme, sur un seul côté de la structure mesa, un décrochement par rapport à la deuxième partie de la deuxième portion de semi-conducteur dopée,
- une première électrode reliée électriquement à la première portion de semi-conducteur dopée, et une deuxième électrode reliée électriquement à la deuxième portion de semi-conducteur dopée au niveau d'une face supérieure de la deuxième partie de la deuxième portion de semi-conducteur dopée,
- des portions diélectriques recouvrant des flancs latéraux de la première portion de semi-conducteur dopée, de la deuxième portion de semi-conducteur dopée et de la première électrode et telles que, au niveau de côtés de la structure mesa ne formant pas le décrochement, les portions diélectriques sont continues le long de toute la hauteur de la structure mesa,
dans laquelle des faces supérieures de la première électrode, de la deuxième électrode et des portions diélectriques forment une surface continue sensiblement plane,
et dans lequel :
- les diodes sont reliées électriquement en série telles que la première électrode d'une des deux diodes soit reliée électriquement à la deuxième électrode de l'autre des deux diodes,
- la deuxième électrode de ladite autre des deux diodes est en contact avec l'une des portions diélectriques de ladite une des deux diodes recouvrant un des côtés de la structure mesa ne formant pas le décrochement.

Ainsi, contrairement aux structures des diodes de l'art antérieur dans lesquelles des couches diélectriques sont successivement déposées sur l'ensemble de la structure pour assurer l'isolation électrique des électrodes des diodes, la diode selon l'invention fait appel à des portions diélectriques, ou portions d'isolation électrique, recouvrant les flancs latéraux des éléments formant la structure mesa de la diode et permettant d'isoler électriquement et de passiver les flancs latéraux de la jonction p-n de la diode, notamment vis-à-vis de la deuxième électrode, et/ou d'isoler électriquement les portions de semi-conducteur dopées de la jonction p-n l'une vis-à-vis de l'autre lorsque celles-ci ne sont pas en contact direct l'une contre l'autre. Ces portions diélectriques permettent également d'assurer l'isolation électrique entre la première et la deuxième électrodes en occupant un minimum de place sur la surface occupée par la diode. Cette localisation des portions diélectriques sur les flancs latéraux de la structure mesa de la diode permet d'améliorer le rapport entre la surface active de la diode (surface occupée par la jonction p-n) et la surface totale sur laquelle la diode est réalisée, et donc d'augmenter l'intégration de ce type de diodes étant donné le faible encombrement des portions diélectriques de cette structure qui sont strictement verticales (parallèles aux flancs latéraux de la structure mesa de la diode qui sont recouverts par ces portions diélectriques).

De plus, cette forte intégration des portions diélectriques a également pour avantage de minimiser les densités de courant obtenues dans les électrodes de la diode, et donc de réduire l'échauffement par effet Joule engendré dans la diode.

L'expression « structure mesa » désigne le fait que la diode est réalisée sous la forme d'un empilement de la première et de la deuxième portions de semi-conducteur dopées, une zone de jonction étant présente entre ces deux portions de semi-conducteur dopées, et que cet empilement est gravé sur au moins une partie de sa hauteur sous forme d'îlot appelé mésa. En outre, cet îlot comporte également, au niveau de la deuxième portion de semi-conducteur dopée, un renfoncement formant une zone de contact électrique de la deuxième portion de semi-conducteur dopée pour la deuxième électrode.

Le décrochement, ou renfoncement, est formé par la première partie de la deuxième portion de semi-conducteur dopée par rapport à la deuxième partie de la deuxième portion de semi-conducteur dopée au niveau d'au moins un côté de la structure mesa. Ce décrochement est aussi formé par la première électrode par rapport à la deuxième partie de la deuxième portion de semi-conducteur dopée. De manière analogue, la deuxième partie de la deuxième portion de semi-conducteur dopée forme, au niveau d'au moins un côté de la structure mesa, une avancée, ou une partie en saillie, par rapport à la première électrode et à la première partie de la deuxième portion de semi-conducteur dopée.

La surface continue sensiblement plane formée par les faces supérieures des électrodes et des portions diélectriques permet d'hybrider facilement, par exemple sans faire appel à des inserts tels que des microbilles de connexion, la diode à un autre élément, tel qu'un substrat permettant de réaliser différentes configurations de connexion de la diode et pouvant comporter également une face plane au niveau de laquelle se trouve des matériaux analogues à ceux de la diode, par exemple par collage direct métal contre métal (pour les électrodes) et diélectrique contre diélectrique (pour les portions diélectriques). Cette surface continue sensiblement plane est également bien adaptée pour la réalisation d'une structure d'interconnexions directement sur les électrodes, évitant ainsi bon nombre de difficultés liées à la topologie résiduelle des structures des diodes de l'art antérieur.

Les faces supérieures de la première électrode, de la deuxième électrode et des portions diélectriques forment une surface continue sensiblement plane, c'est-à-dire sont disposées sensiblement dans un même plan. L'expression « sensiblement plane » est ici utilisée pour désigner le fait que la surface formée par les faces supérieures des électrodes et des portions diélectriques peut présenter des variations de hauteur, ou d'épaisseur, comprises entre environ 0 et 150 nm. Ces légères variations de hauteur ou d'épaisseur peuvent avoir pour origine la mise en oeuvre d'une planarisation mécano-chimique (CMP) mise en oeuvre en présence des matériaux des électrodes et des portions diélectriques, les vitesses de gravure de ces différents matériaux étant différentes les unes des autres. Ces légères variations de hauteur ou d'épaisseur, entre les faces supérieures des portions diélectriques et celles des électrodes, peuvent avoir pour avantage de garantir une excellente isolation entre les électrodes de la diode et/ou vis-à-vis d'électrodes de diodes adjacentes lorsque des creux se situent au niveau des faces supérieures des électrodes.

La liaison série entre les diodes peut être formée au niveau des faces supérieures des électrodes des diodes.

Dans le dispositif électronique selon l'invention, les structures mesa des diodes ont une forme (structure mesa avec un décrochement sur un seul côté) conférant naturellement une isolation électrique entre deux diodes voisines, ne nécessitant pas la réalisation d'un élément d'isolation supplémentaire entre les deuxièmes électrodes de deux diodes voisines reliées en série l'une à l'autre, et cela grâce au fait qu'au niveau de côtés de la structure mesa ne formant pas le décrochement, les portions diélectriques sont continues le long de toute la hauteur de la structure mesa et isolent donc électriquement cette structure mesa vis-à-vis de la deuxième électrode de la diode voisine. Ainsi, les diodes peuvent être aisément mises en série les unes aux autres sans avoir à ajouter des structures d'isolation entre les diodes.

La première électrode, la première portion de semi-conducteur dopée, la première partie de la deuxième portion de semi-conducteur dopée et la deuxième partie de la deuxième portion de semi-conducteur dopée de chacune des diodes peuvent chacune avoir une section, dans un plan parallèle à une interface entre la première et la deuxième parties de la deuxième portion de semi-conducteur dopée, de forme rectangulaire. L'interface entre la première et la deuxième parties de la deuxième portion de semi-conducteur peut être parallèle à la surface continue sensiblement plane.

Dans ce cas, pour chacune des diodes, une dimension d'un côté de la section de la deuxième partie de la deuxième portion de semi-conducteur dopée peut être supérieure à celle d'un côté de la section de la première partie de la deuxième portion de semi-conducteur dopée parallèle au dit côté de la section de la deuxième partie de la deuxième portion de semi-conducteur dopée. Ainsi, le décrochement peut être formé au niveau d'un côté de la structure mesa de la diode. Une telle structure mesa peut avoir une forme de « L ». Cela peut également s'appliquer pour des sections de formes autres que rectangulaire.

Les portions diélectriques peuvent recouvrir uniquement les flancs latéraux de la structure mesa, garantissant ainsi un encombrement minimal des portions diélectriques sur la surface totale occupée par la diode et optimisant le transport de la chaleur via une baisse globale de la résistance thermique de la diode.

La première portion de semi-conducteur peut être dopée p et la deuxième portion de semi-conducteur peut être dopée n, la première électrode pouvant former une anode de la diode et la deuxième électrode pouvant former une cathode de la diode.

Chacune des diodes peut être une photodiode ou une LED.

Dans ce cas, la photodiode peut comporter au moins une portion de semi-conducteur intrinsèque disposée entre la première et la deuxième portions de semi-conducteur dopées et telle que des flancs latéraux de la portion de semi-conducteur intrinsèque soient recouverts par les portions diélectriques, ou dans laquelle la LED comporte au moins une zone active émissive à au moins un puits quantique disposée entre la première et la deuxième portions de semi-conducteur dopées et telle que des flancs latéraux de la zone active émissive soient recouverts par les portions diélectriques.

Les faces supérieures des premières électrodes, des deuxièmes électrodes et des portions diélectriques desdites diodes forment ensemble la surface continue sensiblement plane.

Le dispositif électronique selon l'invention peut avantageusement former un module de LEDs alimentées avec une tension, continue ou alternative, de valeur comprise entre environ la valeur de la tension de fonctionnement d'une des LEDs, par exemple environ 3V, et une valeur correspondant à la somme des tensions de fonctionnement de plusieurs LEDs, par exemple comprise entre 6V et plusieurs centaines des volts, ou entre environ 6V et 50V. Le type (continu ou alternatif) et la valeur de la tension d'alimentation du dispositif électronique peuvent être fonction du nombre de LEDs que comporte le dispositif électronique ainsi que des liaisons électriques reliant les LEDs entre elles (mise en série ou non). Le dispositif électronique peut être adapté pour être alimenté par haute tension, c'est-à-dire par exemple avec une tension de valeur égale à au moins 100V.

Chacune des deuxièmes électrodes peut être en contact avec au moins l'une des portions diélectriques d'une diode voisine. L'intégration des diodes est ainsi maximisée au sein du dispositif électronique du fait que les secondes électrodes peuvent remplir un espace entre deux diodes voisines.

Le dispositif électronique peut comporter en outre une structure de connexion des diodes disposée sur les faces supérieures des premières électrodes, des deuxièmes électrodes et des portions diélectriques, la structure de connexion pouvant comporter au moins des éléments électriquement conducteurs reliés électriquement aux premières et/ou aux deuxièmes électrodes des diodes et isolés électriquement les uns des autres par des éléments diélectriques. Ainsi, le routage et les interconnexions peuvent être réalisés directement sur les électrodes des diodes, dans la structure de connexion, en évitant l'utilisation d'un autre substrat de routage reporté sur les diodes et en limitant les pertes électriques engendrées par le transport des charges à travers ce substrat de routage, ce qui permet également d'optimiser l'intégration du dispositif et limiter les échauffements liés aux pertes par effet Joule.

La valeur de la tension de fonctionnement du dispositif électronique peut être modulée selon les connexions électriques des diodes réalisées au sein de la structure de connexion. Les connexions électriques des diodes peuvent être adaptées pour former un dispositif électronique destiné à être alimenté par une tension continue ou alternative, ou peuvent permettre d'assurer une redondance des diodes en reliant des diodes en parallèles de telle sorte que la défaillance d'une des diodes ne conduise pas à un circuit ouvert et à une défaillance globale du dispositif électronique.

Une face supérieure de la structure de connexion peut former une surface continue plane. Ainsi, il est possible de reporter ou hybrider aisément un circuit ou un substrat sur la structure de connexion, par exemple par collage direct.

Au moins une partie des diodes peuvent être reliées électriquement en série les unes aux autres par au moins une partie des éléments électriquement conducteurs de la structure de connexion, chacun desdits éléments électriquement conducteurs reliant électriquement une deuxième électrode d'une desdites diodes à une première électrode d'une autre desdites diodes. Cette mise en série des diodes sert avantageusement à former un module de LEDs alimentés avec une tension, continue ou alternative, de valeur supérieure à la tension de fonctionnement d'une des LEDs. Une telle structure peut permettre également au dispositif de n'avoir que deux plots d'interconnexion avec l'environnement extérieur, formés par deux des éléments électriquement conducteurs (présentant par exemple une surface de contact de l'ordre du mm²) de la structure de connexion, et ainsi relaxer les contraintes liées à la mise en oeuvre d'un collage aligné d'un driver avec la structure de connexion.

Une telle structure peut également permettre une réduction importante du temps de réponse du dispositif électronique par la diminution des capacités et résistances apparentes pour des alimentations en PWM (pulse wave modulation), par exemple lorsque le dispositif électronique est destiné à réaliser une transmission de données de type Li-Fi.

Chaque élément électriquement conducteur de la structure de connexion peut former un plot de connexion relié électriquement à une seule électrode d'une des diodes, le dispositif électronique pouvant comporter en outre un substrat hybridé sur la structure de connexion et comportant des moyens aptes à former des liaisons électrique entre les éléments électriquement conducteurs de la structure de connexion. Dans ce cas, il est possible de réaliser un adressage individualisé de chacune des électrodes des diodes via le substrat hybridé et les moyens aptes à former les liaisons électriques. De plus, cette configuration peut permettre définir avec beaucoup de liberté la distance entre des éléments électriquement conducteurs de la structure de connexion, cette distance pouvant être supérieures à l'épaisseur des portions diélectriques qui séparent deux électrodes d'une diode.

Il est également décrit un procédé de réalisation d'une diode de structure mesa, comportant au moins les étapes de :
- réalisation d'un empilement de couches comprenant au moins une première couche de semi-conducteur dopée disposée entre une deuxième couche de semi-conducteur dopée et une couche électriquement conductrice,
- gravure de l'empilement de couches, réalisant une première et une deuxième portions de semi-conducteur dopées formant une jonction p-n, la deuxième portion de semi-conducteur dopée comportant une première partie disposée entre une deuxième partie de la deuxième portion de semi-conducteur dopée et la première portion de semi-conducteur dopée et formant un décrochement par rapport à la deuxième partie de la deuxième portion de semi-conducteur dopée, et réalisant une première électrode reliée électriquement à la première portion de semi-conducteur dopée,

- réalisation de portions diélectriques recouvrant des flancs latéraux de la première portion de semi-conducteur dopée, de la deuxième portion de semi-conducteur dopée et de la première électrode,
- dépôt d'au moins un matériau électriquement conducteur en contact avec une face supérieure de la deuxième partie de la deuxième portion de semi-conducteur dopée,
- planarisation du matériau électriquement conducteur avec arrêt sur la première électrode, ou sur des faces supérieures des portions diélectriques, formant une deuxième électrode reliée électriquement à la deuxième portion de semi-conducteur dopée et telle que des faces supérieures de la première électrode, de la deuxième électrode et des portions diélectriques forment une surface continue sensiblement plane.

L'invention propose en outre un procédé de réalisation d'un dispositif électronique comprenant au moins deux diodes de structure mesa, comportant au moins les étapes de :
- réalisation d'un empilement de couches comprenant au moins une première couche de semi-conducteur dopée disposée entre une deuxième couche de semi-conducteur dopée et une couche électriquement conductrice,
- gravure de l'empilement de couches, réalisant, pour chaque diode, une première et une deuxième portions de semi-conducteur dopées formant une jonction p-n, la deuxième portion de semi-conducteur dopée comportant une première partie disposée entre une deuxième partie de la deuxième portion de semi-conducteur dopée et la première portion de semi-conducteur dopée et formant, sur un seul côté de la structure mesa, un décrochement par rapport à la deuxième partie de la deuxième portion de semi-conducteur dopée, et réalisant une première électrode reliée électriquement à la première portion de semi-conducteur dopée,

- réalisation de portions diélectriques recouvrant des flancs latéraux de la première portion de semi-conducteur dopée, de la deuxième portion de semi-conducteur dopée et de la première électrode de chaque diode et telles que, au niveau de côtés de la structure mesa de chaque diode ne formant pas le décrochement, les portions diélectriques sont continues le long de toute la hauteur de la structure mesa,
- dépôt d'au moins un matériau électriquement conducteur entre les structures mesa des diodes et en contact avec une face supérieure de la deuxième partie de la deuxième portion de semi-conducteur dopée de chaque diode,
- planarisation du matériau électriquement conducteur avec arrêt sur la première électrode, formant, pour chaque diode, une deuxième électrode reliée électriquement à la deuxième portion de semi-conducteur dopée et telle que des faces supérieures de la première électrode, de la deuxième électrode et des portions diélectriques forment une surface continue sensiblement plane,
- réalisation d'une liaison électrique reliant électriquement en série les diodes telles que la première électrode d'une des deux diodes soit reliée électriquement à la deuxième électrode de l'autre des deux diodes,
et dans lequel la deuxième électrode de ladite autre des deux diodes est en contact avec l'une des portions diélectriques de ladite une des deux diodes recouvrant un des côtés de la structure mesa ne formant pas le décrochement.

Les portions diélectriques étant déposées sur les flancs latéraux de la structure mesa gravée dans l'empilement de couches, ces portions diélectriques peuvent être réalisées par un procédé auto-aligné permettant d'isoler les électrodes de la diode sans faire appel à un masque spécialement adapté à la réalisation de ces portions diélectriques, par exemple via un dépôt conforme du matériau des portions diélectriques puis une gravure des portions de ce matériau qui ne recouvrent pas les flancs latéraux des structures mesa.

De plus, la réalisation de la deuxième électrode correspond à la mise en oeuvre d'un procédé de type « damascène » dans lequel le matériau électriquement conducteur est formé par un dépôt pleine plaque, la seconde électrode étant obtenue ensuite via une planarisation de ce matériau électriquement conducteur. La réalisation de la deuxième électrode ne nécessite donc pas une étape d'alignement spécifique ou de masquage particulier. L'emplacement de la seconde électrode peut correspondre à un espace formé entre les portions diélectriques recouvrant les flancs latéraux de deux structures mesa voisines.

La gravure de l'empilement de couches peut être mise en oeuvre avec un masque disposé sur l'empilement de couches et comportant, en regard de la première partie de la deuxième portion de semi-conducteur dopée, une première partie d'épaisseur supérieure à celle d'une deuxième partie du masque disposée en regard de la face supérieure de la deuxième partie de la deuxième portion de semi-conducteur dopée destinée à être en contact avec la deuxième électrode.

Les étapes mises en oeuvre peuvent former les diodes de structure mesa dont les faces supérieures des premières électrodes, des deuxièmes électrodes et des portions diélectriques forment ensemble la surface continue sensiblement plane.

Le matériau électriquement conducteur peut être déposé entre les structures mesa des diodes et en contact avec les portions diélectriques desdites diodes.

Le procédé peut comporter en outre, après l'étape de planarisation du matériau électriquement conducteur, la réalisation d'une structure de connexion des diodes sur les faces supérieures des premières électrodes, des deuxièmes électrodes et des portions diélectriques, la structure de connexion comportant au moins des éléments électriquement conducteurs reliés électriquement aux premières et/ou aux deuxièmes électrodes des diodes et isolés électriquement les uns des autres par des éléments diélectriques.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent un dispositif électronique, objet de la présente invention, comportant plusieurs diodes de structure mesa selon un premier mode de réalisation ;
- la figure 3 représente un dispositif électronique, objet de la présente invention, comportant plusieurs diodes de structure mesa selon un deuxième mode de réalisation ;
- les figures 4 et 5A à 5C représentent un autre exemple de réalisation d'un dispositif électronique, objet de la présente invention, comportant plusieurs diodes de structure mesa selon le deuxième mode de réalisation ;
- les figures 6A à 6K représentent les étapes d'un procédé de réalisation d'un dispositif électronique, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

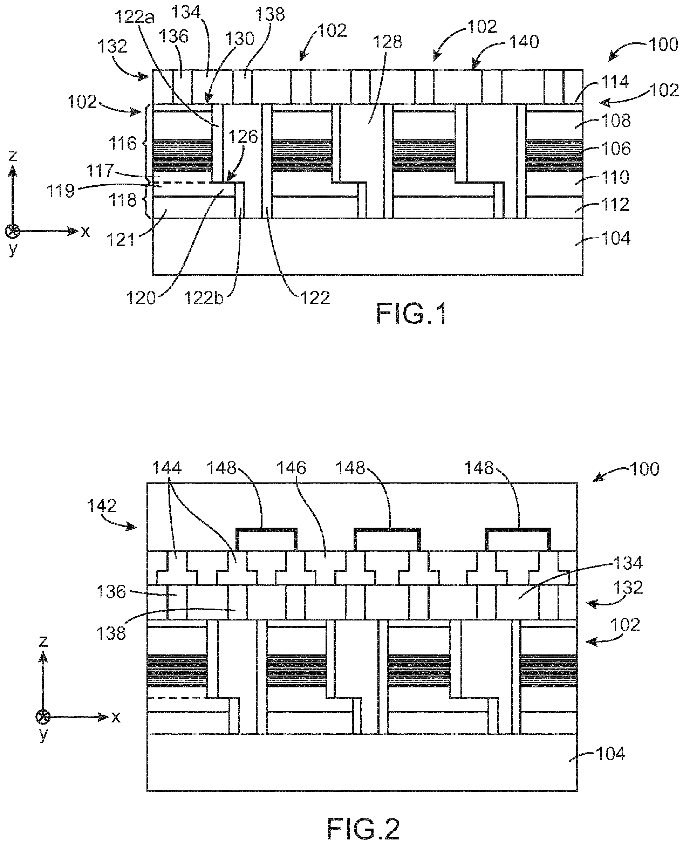

On se réfère tout d'abord à la figure 1 qui représente un dispositif électronique 100 comprenant plusieurs diodes 102 chacune de structure mesa, et selon un premier mode de réalisation. Dans ce premier mode de réalisation, les diodes 102 sont des LEDs et le dispositif 100 correspond à un luminaire à LEDs tel qu'une ampoule à LEDs.

Le dispositif microélectronique 100 comporte un substrat 104, par exemple en saphir, servant de support pour le dépôt ou la croissance des couches destinées à la réalisation des diodes 102. Dans le premier mode de réalisation décrit ici, les diodes 102 sont disposées les unes à côté des autres en formant une matrice de diodes 102, c'est-à-dire sont régulièrement espacées les unes des autres. En variante, les diodes 102 peuvent être réalisées les unes à côté des autres sans former une matrice de diodes, sans espacements réguliers entre elles.

Chacune des diodes 102 comporte une zone active émissive 106. Les zones actives émissives 106 sont réalisées à partir d'une ou plusieurs couches émissives, par exemple cinq, formant chacune un puits quantique, par exemple à base d'InGaN, et étant chacune disposée entre deux couches barrières, par exemple à base de GaN. Toutes les couches des zones actives émissives 106, c'est-à-dire la ou les couches émissives et les couches barrières, comportent des matériaux semi-conducteurs intrinsèques, c'est-à-dire non intentionnellement dopés (de concentration en donneurs résiduels n_{nid} par exemple égale à environ 10¹⁷ donneurs/cm⁻³, ou comprise entre environ 10¹⁵ et 10¹⁸ donneurs/cm³). L'épaisseur de la ou de chacune des couches émissives est par exemple égale à environ 3 nm et plus généralement comprise entre environ 0,5 nm et 10 nm, et l'épaisseur de chacune des couches barrières est par exemple comprise entre environ 1 nm et 25 nm.

La zone active émissive 106 de chacune des diodes 102 est disposée entre une première portion de semi-conducteur dopée p 108 et une deuxième portion de semi-conducteur dopée n 110, les deux portions de semi-conducteur dopées 108 et 110 formant la jonction p-n de la diode 102. Le semi-conducteur des portions 108 et 110 est par exemple du GaN. La première portion 108 est dopée p avec une concentration d'accepteurs par exemple comprise entre environ 10¹⁷ et 5.10¹⁹ accepteurs/cm³, et par exemple égale à environ 5.10¹⁸ accepteurs/cm³. La deuxième portion 110 est dopée n avec une concentration de donneurs par exemple comprise entre environ 10¹⁷ et 5.10¹⁹ donneurs/cm³, et par exemple égale à environ 1.10¹⁹ donneurs/cm³. Les deux portions 108 et 110 ont par exemple chacune une épaisseur comprise entre environ 20 nm et 10 µm.

Dans une variante de réalisation, une couche de blocage d'électrons (non visible sur la figure 1) peut être disposée entre la première portion de semi-conducteur dopée p 108 et la zone active émissive 106, cette couche de blocage d'électrons étant par exemple en AlGaN avec 12% d'aluminium et dopée p avec une concentration d'accepteurs par exemple égale à environ 1.10¹⁷ accepteurs/cm³. Une couche tampon 112 est disposée entre la deuxième portion 110 et le substrat 104. Cette couche tampon 112 est par exemple composée de GaN dopé n et comporte une épaisseur généralement supérieure à environ 100 nm, par exemple de l'ordre d'un micron. Une telle couche tampon 112 sert notamment à filtrer les défauts de croissance afin que ces défauts ne se retrouvent pas dans les jonctions p-n des diodes 102.

Des matériaux autres que ceux cités ci-dessus peuvent être utilisés pour réaliser les diodes 102.

Chaque diode 102 comporte également une première électrode 114 à base d'un matériau électriquement conducteur et disposée sur la première portion de semi-conducteur dopée p 108 et reliée électriquement à celle-ci, formant ici une anode de la diode 102.

Les diodes 102 sont par exemple réalisées via une gravure d'un empilement formé de différentes couches des matériaux précédemment décrits et servant à former les structures mesa des diodes 102, c'est-à-dire des empilements sous forme d'îlots. Chaque structure mesa comporte une partie supérieure 116 formée des portions 114, 108 et 106 ainsi que d'une première partie 117 de la deuxième portion de semi-conducteur dopée 110, et une partie inférieure 118 formée d'une deuxième partie 119 de la deuxième portion de semi-conducteur dopée 110 et d'une partie 121 de la couche tampon. Les parties supérieures 116 et inférieures 118 des structures mesa ont par exemple chacune une section, dans un plan parallèle au plan (X,Y) représenté sur la figure 1 (ce plan (X,Y) étant parallèle au plan dans lequel se trouve l'interface entre les deux parties 117 et 119 de la deuxième portion de semi-conducteur dopée 110, et également parallèle à la surface du substrat 104 sur laquelle les diodes 102 sont réalisées), de forme rectangulaire.

De plus, la largeur de la partie inférieure 118, c'est-à-dire la dimension de la section de la partie inférieure 118 selon l'axe X représenté sur la figure 1, est ici supérieure à celle de la partie supérieure 116. La longueur de la partie inférieure 118, c'est-à-dire la dimension de la section de la partie supérieure 116 selon l'axe Y représenté sur la figure 1, est ici égale à celle de la partie supérieure 116. La structure mesa des diodes 102 a donc ici une forme de « L ». La première partie 117 de la deuxième portion de semi-conducteur dopée 110 forme donc un décrochement par rapport à la deuxième partie 119 de la deuxième portion de semi-conducteur dopée 110.

Ainsi, au niveau d'un côté de la structure mesa de chaque diode 102, une portion 120 de la deuxième partie 119 de la deuxième portion de semi-conducteur dopée 110 n'est pas recouverte par la première partie 117 de la deuxième portion de semi-conducteur dopée 110. Une face supérieure 126 de la deuxième partie 119 de la deuxième portion de semi-conducteur dopée 110 est donc accessible électriquement.

Chaque diode 102 comporte également des portions diélectriques 122 recouvrant les flancs latéraux des structures mesa, c'est-à-dire les flancs latéraux des premières électrodes 114, des premières portions de semi-conducteur dopées 108, des zones actives émissives 106, des deuxièmes portions de semi-conducteur dopées 110 et des portions 121 de la couche tampon 112. Au niveau des côtés de la structure mesa qui ne comportent pas le décrochement, les portions diélectriques 122 qui recouvrent les flancs latéraux de la structure sont continues le long de toute la hauteur de la structure mesa, depuis la face supérieure du substrat 104 jusqu'à la face supérieure de la première électrode 114. Par contre, du côté de la structure mesa qui comporte le décrochement, une première partie 122a de la portion diélectrique 122 recouvre les flancs latéraux de la partie supérieure 116, et une deuxième partie 122b de la portion diélectrique 122 recouvre les flancs latéraux de la partie inférieure 118, ces deux parties 122a et 122b de la portion diélectrique 122 étant discontinues l'une par rapport à l'autre. Les portions diélectriques 122 isolent électriquement et passivent les flancs latéraux des jonctions des diodes 102.

L'épaisseur de la première partie 122a de la portion diélectrique 122 (qui correspond à la dimension selon l'axe X représenté sur la figure 1, et donc parallèle à la largeur des parties 116 et 118) est choisie telle qu'elle ne recouvre que partiellement la face supérieure 126 de la deuxième partie 119 de la deuxième portion dopée n 110 qui est accessible. La portion 120 peut par exemple avoir une largeur (dimension selon l'axe X), au niveau du décrochement formé entre les parties 117 et 119 de la deuxième portion de semi-conducteur dopée 110, au moins égale à environ 1% de la largeur de la partie supérieure 116. Par exemple, pour une partie supérieure 116 de largeur égale à environ 80 µm, la largeur de la portion 120 peut être égale à environ 5 µm.

Les dimensions des côtes de la structure mesa peuvent être comprises entre environ 500 nm et 1 mm, ou entre 500 nm et plusieurs millimètres, selon les applications visées, ces dimensions concernant la partie supérieure 116 et la partie inférieure 118 de la structure mesa (avec une différence d'au moins 1 % entre les deux parties 116 et 118). Pour des applications faisant appel à des diodes de forte puissance (par exemple des ampoules LEDs pour former des phares de voiture), les dimensions des diodes 102 seront plus importantes que pour des applications faisant appel à des diodes 102 de plus faible puissance.

L'espace entre deux diodes 102 est rempli par un matériau électriquement conducteur formant, entre les diodes 102, des deuxièmes électrodes 128. Chacun des deuxièmes électrodes 128 repose sur le substrat 104 et est en contact électriquement avec la face supérieure 126 de la deuxième partie 119 de la deuxième portion dopée n 110 d'une des diodes 102. Ainsi, chacune des deuxièmes électrodes 128 est reliée électriquement à une deuxième portion de semi-conducteur dopée 110 d'une des diodes 102, et forme ici une cathode de cette diode 102.

La largeur d'une deuxième électrode 128, c'est-à-dire la dimension de la deuxième électrode 128 entre deux structures mesa de diodes 102 (dimension parallèle à l'axe X représenté sur la figure 1), est dimensionnée en fonction des pertes acceptables liées à l'amenée du courant électrique. Cette largeur est par exemple comprise entre environ 100 nm et plusieurs millimètres ou plus. La longueur de la deuxième électrode 102 (dimension parallèle à l'axe Y représenté sur la figure 1) est par exemple égale à celle des structures mesa des diodes 102.

Les deuxièmes électrodes 128 ont chacune une section, dans le plan (X,Y), de forme similaire à celle des motifs gravés dans l'empilement de couches. Ainsi, chacune des deuxièmes électrodes 128 comporte une section, dans le plan (X,Y), dont les dimensions, parallèlement à l'axe X, au niveau de la partie de la deuxième électrode 128 en contact avec la première partie 122a de la portion diélectrique 122b sont inférieures à celles de la partie de la deuxième électrode 128 en contact avec la deuxième partie 122b de la portion diélectrique 122.

Grâce aux portions diélectriques 122 verticales, les deuxièmes électrodes 128 sont bien isolées électriquement des premières électrodes 114, des premières portions de semi-conducteur 108 et des zones actives émissives 106. L'épaisseur des portions diélectriques 122 est choisie notamment en fonction de la constante diélectrique du matériau formant ces portions diélectriques 122 et peut être choisie telle que ces portions 122 présentent un courant de fuite acceptable dans chacune des diodes 102, par exemple inférieur à environ 1 % du courant nominal traversant la diode 102, lorsqu'elles sont soumises à une différence de potentiels (entre la cathode et l'anode entourant chacune de ces portions 122) par exemple de l'ordre de 4V. L'épaisseur minimale des portions diélectriques 122 est par exemple comprise entre environ 3 nm et 5 nm, ou entre 3 nm et 4 nm, en fonction du matériau utilisé pour réaliser les portions diélectriques 122.

Etant donné les structures mesa formées par les diodes 102 et la géométrie des deuxièmes électrodes 128, les faces supérieures des premières électrodes 114, des portions diélectriques 122 et des deuxièmes électrodes 128 forment ensemble une surface 130 sensiblement plane, c'est-à-dire sont disposées sensiblement dans un même plan. En effet, étant donné l'étape de planarisation du matériau des deuxièmes électrodes 128 mise en oeuvre lors de la réalisation du dispositif 100 (étape décrite plus loin en liaison avec le procédé de réalisation), les faces supérieures des premières électrodes 114 et celles des deuxièmes électrodes 128 peuvent présenter des creux de profondeurs (par rapport aux faces supérieures des portions diélectriques 122) comprises entre environ 5 nm et 150 nm. Ces creux ont toutefois pour avantage de garantir l'isolation électrique entre les électrodes 114 et 128 réalisée par les portions diélectriques 122.

Le dispositif 100 comporte également, sur la surface 130, une structure de connexion 132 formant les connexions électriques des diodes 102. Dans le premier mode de réalisation représenté sur la figure 1, cette structure de connexion 132 comporte des premiers éléments électriquement conducteurs 136 reliés électriquement aux premières électrodes 114 des diodes 102 et des deuxièmes éléments électriquement conducteurs 138 reliés électriquement aux deuxièmes électrodes 128 des diodes 102. Les éléments électriquement conducteurs 136, 138 sont isolés électriquement les uns des autres par des éléments diélectriques 134 dont les dimensions, dans le plan (X,Y), sont au moins égales à celles des portions diélectriques 122 afin que les éléments électriquement conducteurs 136 et 138 ne forment pas de courts-circuits entre les électrodes des diodes 102. L'épaisseur de la structure de connexion 132 (dimension selon l'axe Z représenté sur la figure 1) est par exemple supérieure ou égale à environ 20 nm.

Dans ce premier mode de réalisation, les éléments électriquement conducteurs 136 et 138 ne sont pas reliés électriquement entre eux, l'anode et la cathode de chacune des diodes 102 étant accessibles indépendamment l'une de l'autre via les éléments électriquement conducteurs 136 et 138. Les diodes 102 peuvent ainsi former une matrice de diodes générique à partir de laquelle tout type de connexion électrique des diodes 102 est possible. De plus, une surface supérieure 140 de la structure de connexion 132 est plane et donc bien adaptée pour être hybridée directement avec un autre élément, par exemple un substrat comportant un driver permettant de réaliser un pilotage et un adressage adapté des diodes 102 permettant de gérer les connexions électriques (mise en série, en parallèle, etc.) des diodes 102 par exemple de manière à suivre la tension d'alimentation du dispositif 100.

La figure 2 représente le dispositif 100 selon le premier mode de réalisation et comportant un substrat 142 tel que décrit ci-dessus et hybridé sur la face supérieure 140 de la structure de connexion 132. Ce substrat 142 comporte, au niveau de l'interface avec la face supérieure 140, des plots de connexion électrique 144 en contact électriquement avec les éléments électriquement conducteurs 136 et 138, ces plots de connexion électrique 144 étant isolés électriquement les uns des autres par un matériau diélectrique 146 en contact avec les éléments diélectriques 134. Ce substrat 142 comporte également une électronique de commande, non visible sur la figure 2, permettant de gérer les interconnexions entre les plots de connexion électrique 144. Sur la figure 2, des interconnexions 148 sont paramétrées pour relier en série au moins une partie des diodes 102 du dispositif 100. Le substrat 142 est ici solidarisé à la structure de connexion 132 par collage direct métal-métal entre les plots de connexion électrique 144 et les éléments électriquement conducteur 136, 138, et par collage direct diélectrique-diélectrique entre le matériau diélectrique 146 et les éléments diélectriques 134.

Dans le premier mode de réalisation décrit ici, le dispositif électronique 100 est un dispositif d'éclairage à LEDs, les diodes 102 correspondant à des LEDs. En variante, le dispositif électronique 100 peut comporter des diodes 102 correspondant à des diodes photo-réceptrices, ou photodiodes. Dans ce cas, l'élément référencé 106 de chaque diode 102 disposé entre les portions de semi-conducteur 108 et 110 respectivement dopées p et n peut correspondre à une portion de semi-conducteur intrinsèque. De plus, dans cette variante, les anodes 114 et cathodes 128 des diodes 102 ne servent pas à fournir un courant d'alimentation aux diodes 102 mais servent à récupérer des courants photo-générés par les diodes 102.

Selon une autre variante, que les diodes 102 correspondent à des LEDs ou à des photodiodes, les structures mesa des diodes 102 peuvent ne pas comporter les zones émissives 106 ou les portions de semi-conducteur intrinsèque, et les premières portions de semi-conducteur dopées p 108 sont alors disposées directement sur les deuxièmes portions de semi-conducteur dopées n 110. Les autres éléments d'un tel dispositif électronique sont similaires à ceux du dispositif électronique 100 précédemment décrit.

Dans le premier mode de réalisation précédemment décrit, les structures mesa des diodes 102 comportent des sections de forme rectangulaire. En variante, les diodes 102 peuvent être réalisées en formant des structures mesa de section de forme autre que rectangulaire, par exemple circulaire, triangulaire, etc. Dans tous les cas, un renfoncement est formé au niveau d'une interface entre deux parties de la deuxième portion dopée 110 afin de former un accès électrique à cette deuxième portion de semi-conducteur dopée 110 pour la deuxième électrode 128.

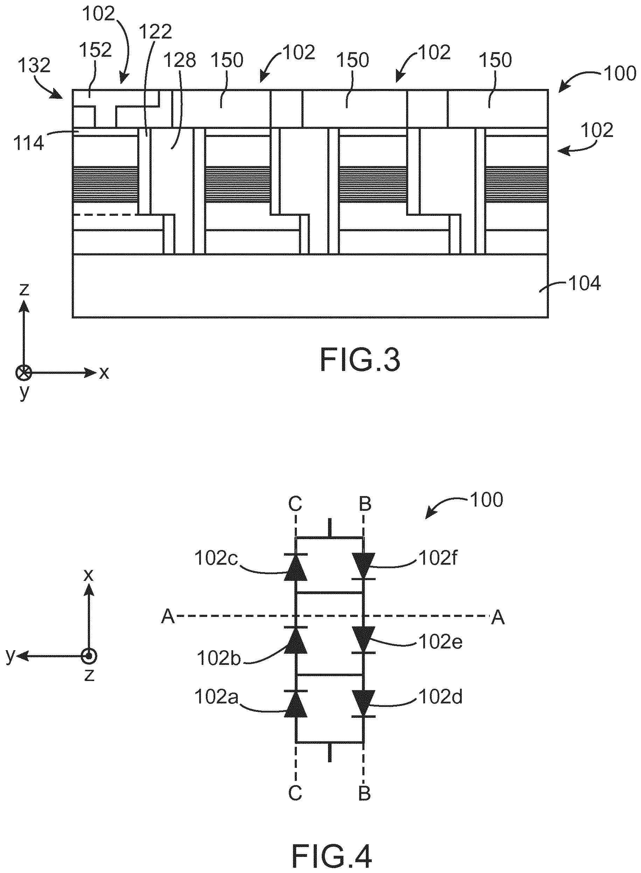

La figure 3 représente le dispositif électronique 100 selon un deuxième mode de réalisation.

Comme dans le premier mode de réalisation, le dispositif 100 comporte le substrat 104 sur lequel sont formées les diodes 102 de structure mesa et comportant les électrodes 114 et 128 et les portions diélectriques 122. Le dispositif 100 comporte également la structure de connexion 132. Par contre, les éléments électriquement conducteurs de cette structure de connexion 132 diffèrent de ceux précédemment décrit dans le premier mode de réalisation. En effet, chacun des éléments électriquement conducteurs 150 de cette structure de connexion 132 relie la cathode 128 d'une première diode 102 à l'anode 114 d'une deuxième diode 102 voisine de la première. Ainsi, chaque élément de connexion électrique 150 forme une liaison électrique reliant en série deux diodes voisines.

La structure de connexion 132 comporte également deux autres éléments électriquement conducteurs 152 (un seul est représenté sur la figure 3) qui ne relient pas en série deux diodes 102 mais qui forment des plots d'accès électrique aux diodes 102 depuis la cathode ou l'anode de l'une des diodes 102. Il est par exemple possible d'avoir deux plots d'accès 152 formant des contacts électriques de deux extrémités d'un ensemble de diodes 102 reliées en série les unes aux autres, l'une des deux extrémités étant formée par l'anode d'une première diode 102 et l'autre extrémité étant formée par la cathode d'une dernière diode 102, ces deux plots d'accès permettant d'alimenter électriquement les diodes 102 via la connexion d'un driver externe à ces deux plots, un tel driver permettant par exemple de réguler en courant le dispositif 100 à partir d'un branchement directement sur le secteur.

La figure 4 représente schématiquement un exemple de réalisation du dispositif 100 selon le deuxième mode de réalisation, formant un module composé de six LEDs 102.

Le dispositif 100 comporte trois LEDs 102a, 102b et 102c reliées électriquement en série entre elles, et trois autres LEDs 102d, 102e et 102f reliées électriquement en série entre elles et disposées tête bêche aux trois LEDs 102a, 102b et 102c. La cathode de la LED 102a qui est reliée électriquement à l'anode de la LED 102b est également reliée électriquement à l'anode de la LED 102d et à la cathode de la LED 102e. La cathode de la LED 102b qui est reliée électriquement à l'anode de la LED 102c est également reliée électriquement à l'anode de la LED 102e et à la cathode de la LED 102f. De plus, la cathode de la LED 102c est reliée électriquement à l'anode de la LED 102f, et l'anode de la LED 102a est reliée électriquement à la cathode de la LED 102d. Le dispositif 100 est alimenté électriquement en appliquant une tension d'alimentation entre deux bornes, l'une étant reliée électriquement à la cathode de la LED 102c (et donc également à l'anode de la LED 102f) et l'autre étant reliée électriquement à l'anode de la LED 102a (et donc également à la cathode de la LED 102d).

Du fait que les LEDs sont reliées en série trois par trois entre les deux bornes d'alimentation du dispositif 100, la tension de fonctionnement du dispositif 100 est d'environ 9V (la tension de fonctionnement de chacune des LEDs étant d'environ 3V). De plus, les LEDs 102a, 102b et 102c étant disposées tête-bêche par rapport aux LEDs 102d, 102e et 102f, le dispositif 100 est adapté pour être alimenté électriquement par une tension alternative.

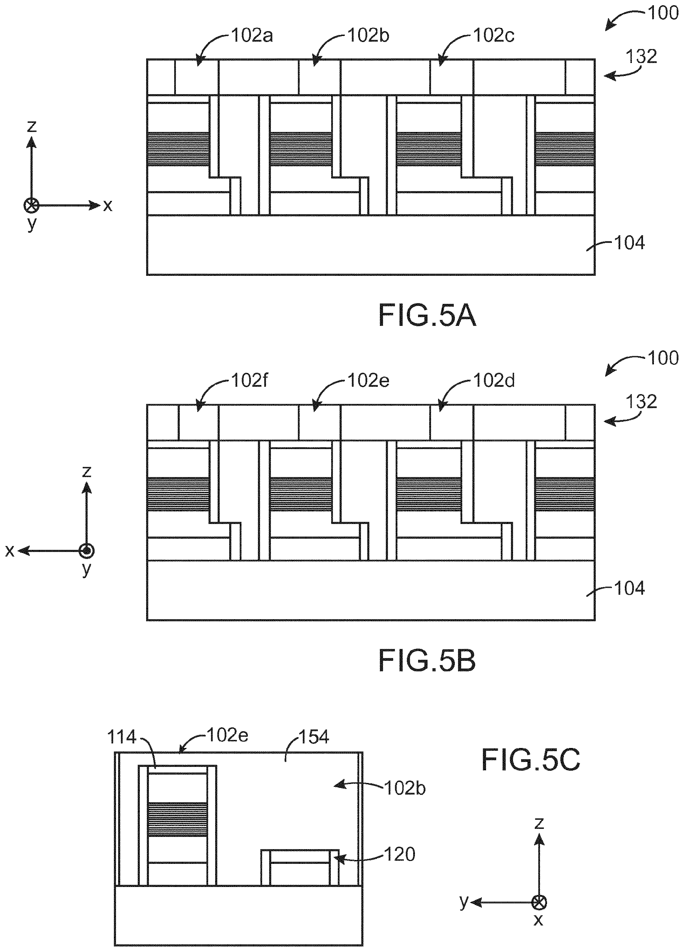

La figure 5A représente une vue en coupe du dispositif 100 selon l'axe CC représenté sur la figure 4, c'est-à-dire le long des trois LEDs 102a, 102b et 102c reliées en série les unes aux autres. La figure 5B représente une vue en coupe du dispositif 100 selon l'axe BB représenté sur la figure 4, c'est-à-dire le long des trois LEDs 102d, 102e et 102f reliées en série les unes aux autres. Les éléments visibles sur ces figures 5A et 5B correspondent à ceux précédemment décrits en liaison avec la figure 3.

La figure 5C représente une vue en coupe du dispositif 100 selon l'axe AA représenté sur la figure 4, c'est-à-dire coupant transversalement les LEDs 102b et 102e. On voit notamment sur cette figure que du matériau électriquement conducteur 154 relie ici l'anode de la LED 102e à la cathode de la LED 102b qui est en contact avec la portion 120 de la structure mesa de la LED 102b, au niveau de la face supérieure 126 de la deuxième partie 119 de la deuxième portion de semi-conducteur dopée 110 de la LED 102b.

Dans l'exemple décrit sur les figures 4 et 5A-5C, la liaison électrique entre la cathode de la LED 102a et l'anode de la LED 102d et la liaison électrique entre la cathode de la LED 102b et l'anode de la LED 102e permettent qu'en cas de défaillance d'une des LEDs, cette défaillance ne conduise pas à la formation d'un circuit ouvert et à une défaillance globale du dispositif 100.

En variante, le dispositif 100 de la figure 4 pourrait comporter un nombre plus ou moins important de LEDs reliées en série les unes autres. Il est également possible de former un dispositif 100 alimenté par une tension d'alimentation continue en réalisant le dispositif 100 à partir d'un seul ensemble de LEDs reliées en série entre elles, la tension d'alimentation étant dans ce cas appliquée entre une première borne correspondant à l'anode de la première LED et une deuxième borne correspondant à la cathode de la dernière LED.

Selon une autre variante, il est également possible que le dispositif 100 comporte une ou plusieurs autres LEDs permettant d'assurer une redondance des six LEDs 102a-102f. Ainsi, le dispositif 100 pourrait comporter trois autres LEDs 102 reliées en série entre elles, cet ensemble de trois LEDs étant relié en parallèle aux trois LEDs 102a à 102c et permettant ainsi d'assurer une redondance vis-à-vis des trois LEDs 102a - 102c. Une redondance similaire peut être réalisée pour les trois LEDs 102d à 102f avec trois autres LEDs.

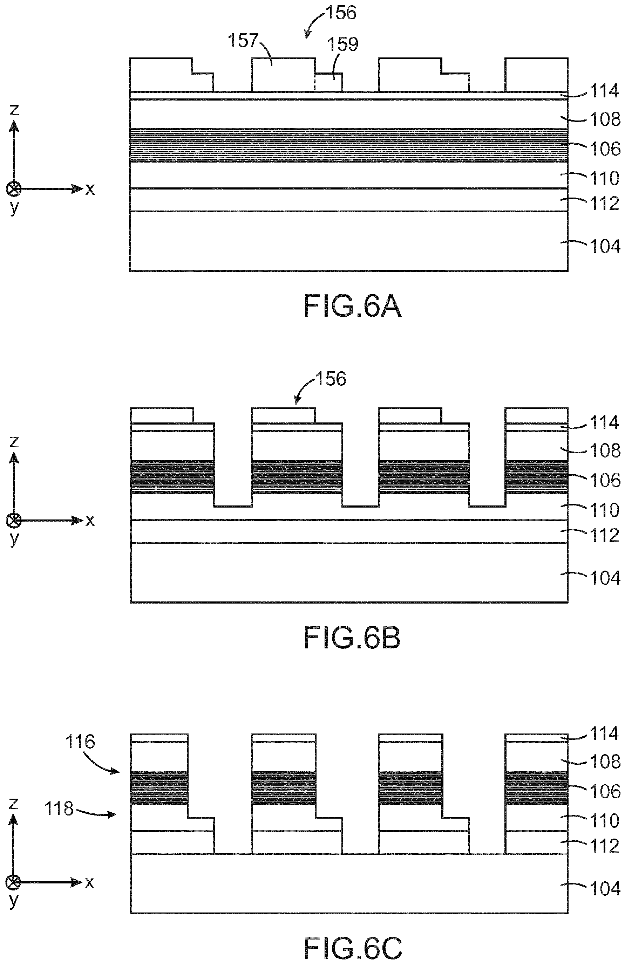

Un procédé de réalisation du dispositif 100 est décrit en liaison avec les figures 6A à 6K.

Un empilement des différentes couches destinées à former les éléments 112, 110, 106, 108 et 114 des diodes 102 est tout d'abord réalisé sur le substrat 104. Un masque dur 156 est également réalisé au sommet de cet empilement de couches. Le motif de ce masque dur 156 correspond à celui des structures mesa des diodes 102 destinées à être réalisées par gravure dans l'empilement de couches (figure 6A). Ainsi, ce masque 156 comporte, en regard de la première partie 117 de la deuxième portion de semi-conducteur dopée 110 destinée à être formée, une première partie 157 d'épaisseur supérieure à celle d'une deuxième partie 159 du masque disposée en regard de la face supérieure 126 de la deuxième partie 119 de la deuxième portion de semi-conducteur dopée 110 destinée à être en contact avec la deuxième électrode 128 qui sera formée. Les épaisseurs de ces deux parties 157, 159 du masque 156 sont choisies en fonction de la vitesse avec laquelle seront gravés les différents matériaux de l'empilement de couches.

Comme représenté sur la figure 6B, une gravure de l'empilement de couches est réalisée jusqu'à un niveau de profondeur se situant dans la couche de semi-conducteur dopé n servant à former les portions 110. Cette gravure « consomme » le masque 156 sur une épaisseur égale à celle de la deuxième partie 159. Cette gravure permet de définir dans l'empilement de couches une partie des espaces dans lesquels les deuxièmes électrodes 128 seront réalisées. Cette gravure est poursuivie ensuite à travers les parties de l'empilement non recouvertes par les portions restantes du masque dur 156, ce qui permet d'achever la formation des parties supérieures 116 des structures mesa et de former également les parties inférieures 118 des structures mesa (figure 6C).

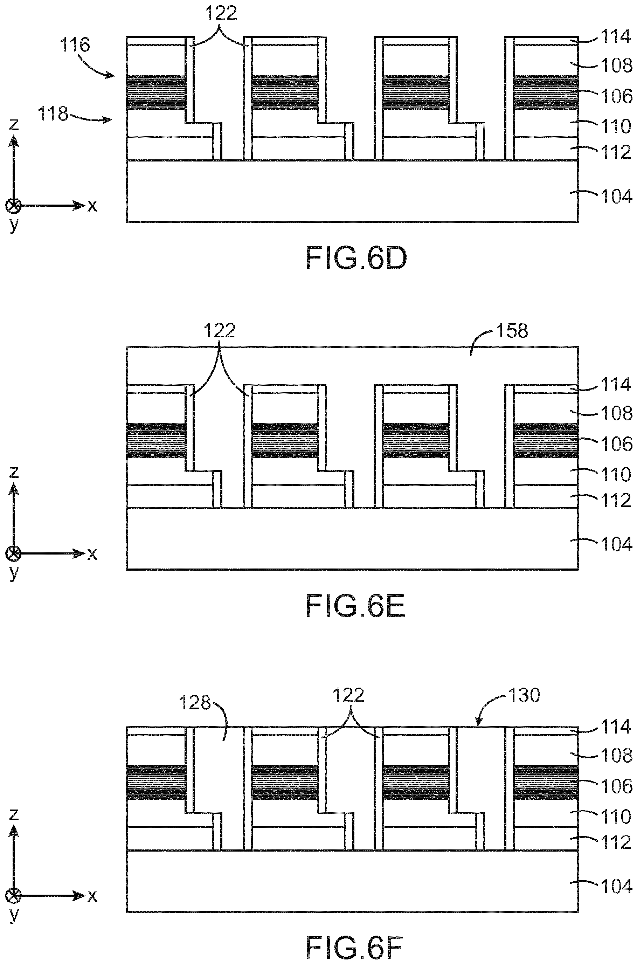

Les éventuelles portions restantes du masque dur 156 sont ensuite supprimées, puis les portions diélectriques 122 sont réalisées sur les flancs latéraux des structures mesa précédemment gravées dans l'empilement de couches (figure 6D). Les portions diélectriques 122 sont par exemple réalisées par un dépôt de type PECVD (dépôt chimique en phase vapeur assisté par plasma) ou ALD (dépôt de couche atomique) selon le matériau déposé. Ce dépôt de matériau diélectrique est réalisé sur les flancs latéraux des structures mesa, mais également sur et entre les structures mesa. Seules les portions de ce dépôt recouvrant les flancs latéraux sont conservées en réalisant, après le dépôt, une gravure, par exemple de type RIE (gravure ionique réactive), des parties du matériau diélectrique déposées sur et entre les structures mesa.

Comme représenté sur la figure 6E, un dépôt pleine plaque d'un matériau électriquement conducteur 158 est ensuite mis en oeuvre tel que les espaces entre les structures mesa des diodes 102 soient remplis de ce matériau électriquement conducteur. Le matériau électriquement conducteur déposé recouvre également les structures mesa compte tenu du dépôt pleine plaque réalisé.

Une planarisation mécano-chimique est ensuite mise en oeuvre avec arrêt au niveau des faces supérieures des portions diélectriques 122 afin de supprimer les parties du matériau électriquement conducteur 158 recouvrant les structures mesa. Le matériau électriquement conducteur restant forme les deuxièmes électrodes 128, c'est-à-dire les cathodes des diodes 102 (figure 6F). Du fait que la vitesse d'abrasion du métal formant les électrodes 114 et 128 est supérieure à celle du matériau diélectrique des portions 122, cette étape de CMP peut former des légers creux au niveau des électrodes 114 et 128 par rapport aux faces supérieures des portions diélectriques 122, comme précédemment décrit. La face supérieure obtenue reste toutefois sensiblement plane et bien adaptée pour réaliser une hybridation ultérieure par exemple par collage direct.

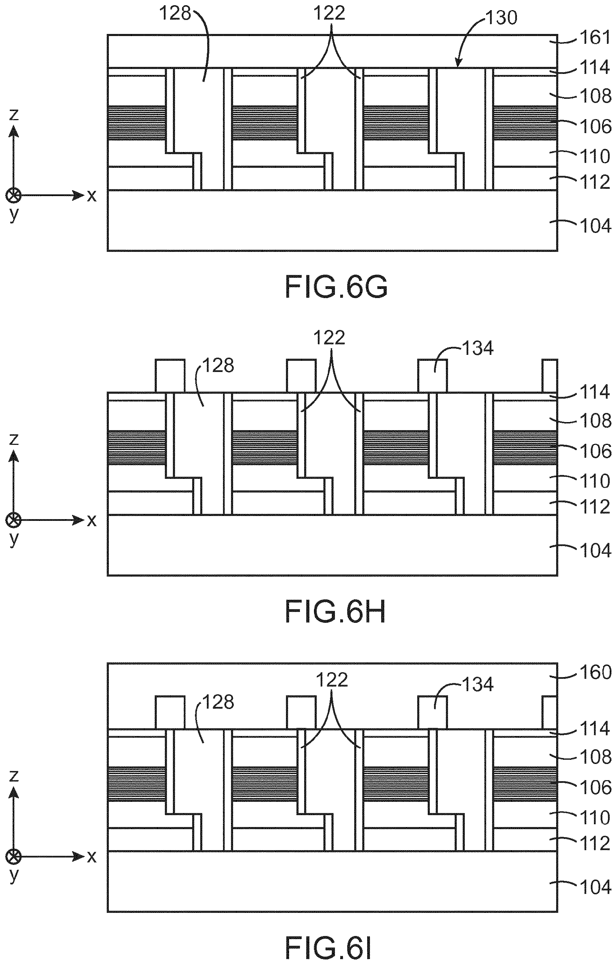

Comme représenté sur la figure 6G, une couche diélectrique 161 est ensuite déposée sur l'ensemble précédemment réalisé. Une lithographie et une gravure sont ensuite mise en oeuvre afin de définir les éléments diélectriques 134 de la future structure de connexion 132, et des cavités, entre ces éléments diélectriques 134, définissant les emplacements des futurs éléments électriquement conducteurs de la structure de connexion 132 (figure 6H). Le motif de cette lithographie est notamment choisi en fonction des connexions électriques souhaitées pour les diodes 102 (mise en série, connexions individuelles de chaque électrode, etc.).

Un autre dépôt pleine plaque d'au moins un matériau électriquement conducteur 160 est réalisé (figure 6I). Ce dépôt de matériau électriquement conducteur peut par exemple correspondre à la mise en oeuvre d'un premier de dépôt de titane sur une épaisseur d'environ 10 nm, puis un second dépôt d'aluminium sur une épaisseur d'environ 3 µm. Ce ou ces matériaux électriquement conducteurs remplissent notamment les espaces entre les éléments diélectriques 134.

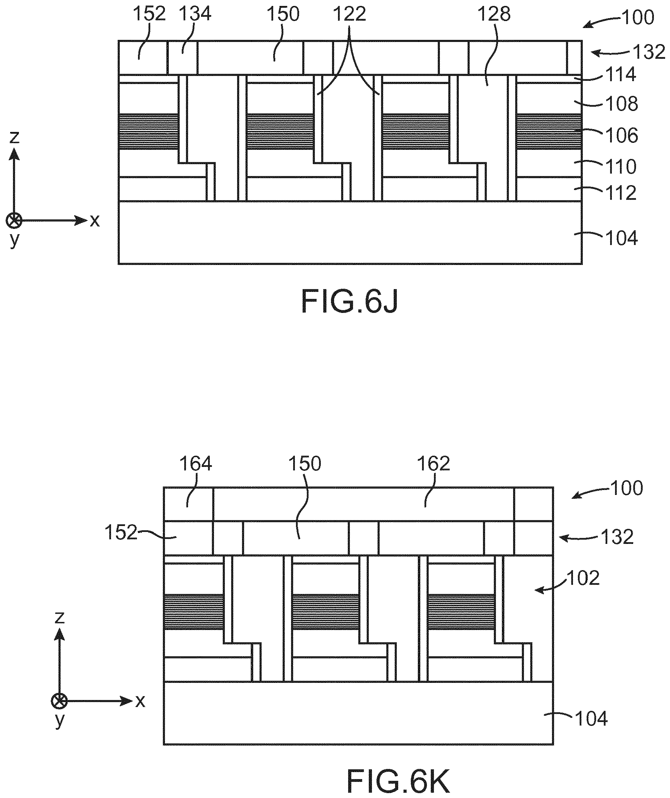

Une planarisation mécano-chimique est réalisée avec arrêt sur les éléments diélectrique 134, définissant ainsi les éléments électriquement conducteurs 150 reliés aux anodes et aux cathodes des diodes 102, ainsi que les éléments électriquement conducteurs 152 formant les plots de contact de la structure de connexion 132. Sur l'exemple de la figure 6J, les éléments électriquement conducteurs relient en série les diodes 102. Le dispositif électronique 100 ainsi obtenu correspond à celui précédemment décrit en liaison avec la figure 2.

Comme représenté sur la figure 6K, il est possible de compléter la structure de connexion 132 en réalisant un dépôt de diélectrique 162 recouvrant les éléments électriquement conducteurs 150, suivie d'une gravure de ce diélectrique au niveau des éléments électriquement conducteurs 152 destinés à former les plots d'accès du dispositif 100, puis en déposant un métal pour prolonger ces plots d'accès à côté du dépôt diélectrique 162. Ainsi, les éléments électriquement conducteurs 150 formant les connexions entre les diodes 102 du dispositif 100 ne sont pas accessibles depuis l'extérieur du dispositif 100. Seuls les plots de contacts électriques 164 sont accessibles depuis l'extérieur du dispositif 100.

## Revendications

1. Dispositif électronique (100) comprenant au moins deux diodes (102) de structure mesa, chaque diode (102) comportant au moins :
- une première (108) et une deuxième (110) portions de semi-conducteur dopées formant une jonction p-n et telles qu'une première partie (117) de la deuxième portion de semi-conducteur dopée (110) disposée entre une deuxième partie (119) de la deuxième portion de semi-conducteur dopée (110) et la première portion de semi-conducteur dopée (108) forme, sur un seul côté de la structure mesa, un décrochement par rapport à la deuxième partie (119) de la deuxième portion de semi-conducteur dopée (110),
- une première électrode (114) reliée électriquement à la première portion de semi-conducteur dopée (108), et une deuxième électrode (128) reliée électriquement à la deuxième portion de semi-conducteur dopée (110) au niveau d'une face supérieure (126) de la deuxième partie (119) de la deuxième portion de semi-conducteur dopée (110),
- des portions diélectriques (122) recouvrant des flancs latéraux de la première portion de semi-conducteur dopée (108), de la deuxième portion de semi-conducteur dopée (110) et de la première électrode (114) et telles que, au niveau de côtés de la structure mesa ne formant pas le décrochement, les portions diélectriques (122) sont continues le long de toute la hauteur de la structure mesa,
dans laquelle des faces supérieures de la première électrode (114), de la deuxième électrode (128) et des portions diélectriques (122) forment une surface continue sensiblement plane (130),
et dans lequel :
- les diodes (102) sont reliées électriquement en série telles que la première électrode (114) d'une des deux diodes (102) soit reliée électriquement à la deuxième électrode (128) de l'autre des deux diodes (102),
- la deuxième électrode (128) de ladite autre des deux diodes (102) est en contact avec l'une des portions diélectriques (122) de ladite une des deux diodes (102) recouvrant un des côtés de la structure mesa ne formant pas le décrochement.

2. Dispositif électronique (100) selon la revendication 1, dans lequel la première électrode (114), la première portion de semi-conducteur dopée (108), la première partie (117) de la deuxième portion de semi-conducteur dopée (110) et la deuxième partie (119) de la deuxième portion de semi-conducteur dopée (110) de chacune des diodes (102) ont chacune une section, dans un plan parallèle à une interface entre la première (117) et la deuxième (119) parties de la deuxième portion de semi-conducteur dopée (110), de forme rectangulaire.

3. Dispositif électronique (100) selon la revendication 2, dans lequel, pour chacune des diodes (102), une dimension d'un côté de la section de la deuxième partie (119) de la deuxième portion de semi-conducteur dopée (110) est supérieure à celle d'un côté de la section de la première partie (117) de la deuxième portion de semi-conducteur dopée (110) parallèle au dit côté de la section de la deuxième partie (119) de la deuxième portion de semi-conducteur dopée (110).

4. Dispositif électronique (100) selon l'une des revendications précédentes, dans lequel chacune des diodes (102) est une photodiode ou une LED.

5. Dispositif électronique (100) selon la revendication 4, dans laquelle la photodiode (102) comporte au moins une portion de semi-conducteur intrinsèque (106) disposée entre la première (108) et la deuxième (110) portions de semi-conducteur dopées et telle que des flancs latéraux de la portion de semi-conducteur intrinsèque soient recouverts par les portions diélectriques (112), ou dans laquelle la LED (102) comporte au moins une zone active émissive (106) à au moins un puits quantique disposée entre la première (108) et la deuxième (110) portions de semi-conducteur dopées et telle que des flancs latéraux de la zone active émissive (106) soient recouverts par les portions diélectriques (122).

6. Dispositif électronique (100) selon l'une des revendications précédentes, dans lequel les faces supérieures des premières électrodes (114), des deuxièmes électrodes (128) et des portions diélectriques (122) desdites diodes (102) forment ensemble la surface continue sensiblement plane (130).

7. Dispositif électronique (100) selon l'une des revendications précédentes, comportant en outre une structure de connexion (132) des diodes (102) disposée sur les faces supérieures des premières électrodes (114), des deuxièmes électrodes (128) et des portions diélectriques (122), la structure de connexion (132) comportant au moins des éléments électriquement conducteurs (136, 138, 150) reliés électriquement aux premières (114) et/ou aux deuxièmes (128) électrodes des diodes (102) et isolés électriquement les uns des autres par des éléments diélectriques (134).

8. Dispositif électronique (100) selon la revendication 7, dans lequel une face supérieure (140) de la structure de connexion (132) forme une surface continue plane.

9. Dispositif électronique (100) selon l'une des revendications 7 ou 8, dans lequel au moins une partie des diodes (102) sont reliées électriquement en série les unes aux autres par au moins une partie des éléments électriquement conducteurs (150) de la structure de connexion (132), chacun desdits éléments électriquement conducteurs (150) reliant électriquement une deuxième électrode (128) d'une desdites diodes (102) à une première électrode (114) d'une autre desdites diodes (102).

10. Dispositif électronique (100) selon la revendication 7 ou 8, dans lequel chaque élément électriquement conducteur (136, 138) de la structure de connexion (132) forme un plot de connexion relié électriquement à une seule électrode (114, 128) d'une des diodes (102), le dispositif électronique (100) comportant en outre un substrat (142) hybridé sur la structure de connexion (132) et comportant des moyens aptes à former des liaisons électrique (148) entre les éléments électriquement conducteurs (136, 138) de la structure de connexion (132).

11. Procédé de réalisation d'un dispositif électronique (100) comprenant au moins deux diodes (102) de structure mesa, comportant au moins les étapes de :
- réalisation d'un empilement de couches comprenant au moins une première couche de semi-conducteur dopée (108) disposée entre une deuxième couche de semi-conducteur dopée (110) et une couche électriquement conductrice (114),
- gravure de l'empilement de couches, réalisant, pour chaque diode (102), une première (108) et une deuxième (110) portions de semi-conducteur dopées formant une jonction p-n, la deuxième portion de semi-conducteur dopée (110) comportant une première partie (117) disposée entre une deuxième partie (119) de la deuxième portion de semi-conducteur dopée (110) et la première portion de semi-conducteur dopée (108) et formant, sur un seul côté de la structure mesa, un décrochement par rapport à la deuxième partie (119) de la deuxième portion de semi-conducteur dopée (110), et réalisant une première électrode (114) reliée électriquement à la première portion de semi-conducteur dopée (108),
- réalisation de portions diélectriques (122) recouvrant des flancs latéraux de la première portion de semi-conducteur dopée (108), de la deuxième portion de semi-conducteur dopée (110) et de la première électrode (114) de chaque diode (102) et telles que, au niveau de côtés de la structure mesa de chaque diode (102) ne formant pas le décrochement, les portions diélectriques (122) sont continues le long de toute la hauteur de la structure mesa,
- dépôt d'au moins un matériau électriquement conducteur (158) entre les structures mesa des diodes (102) et en contact avec une face supérieure (126) de la deuxième partie (119) de la deuxième portion de semi-conducteur dopée (110) de chaque diode (102),
- planarisation du matériau électriquement conducteur (158) avec arrêt sur la première électrode (114), formant, pour chaque diode (102), une deuxième électrode (128) reliée électriquement à la deuxième portion de semi-conducteur dopée (110) et telle que des faces supérieures de la première électrode (114), de la deuxième électrode (128) et des portions diélectriques (122) forment une surface continue sensiblement plane (130),
- réalisation d'une liaison électrique reliant électriquement en série les diodes (102) telles que la première électrode (114) d'une des deux diodes (102) soit reliée électriquement à la deuxième électrode (128) de l'autre des deux diodes (102),
et dans lequel la deuxième électrode (128) de ladite autre des deux diodes (102) est en contact avec l'une des portions diélectriques (122) de ladite une des deux diodes (102) recouvrant un des côtés de la structure mesa ne formant pas le décrochement.

12. Procédé selon la revendication 11, dans lequel la gravure de l'empilement de couches est mise en oeuvre avec un masque (156) disposé sur l'empilement de couches et comportant, en regard de la première partie (117) de la deuxième portion de semi-conducteur dopée (110), une première partie (157) d'épaisseur supérieure à celle d'une deuxième partie (159) du masque (156) disposée en regard de la face supérieure (126) de la deuxième partie (119) de la deuxième portion de semi-conducteur dopée (110) destinée à être en contact avec la deuxième électrode (128).

13. Procédé selon l'une des revendications 11 ou 12, dans lequel les étapes mises en oeuvre forment les diodes (102) de structure mesa dont les faces supérieures des premières électrodes (114), des deuxièmes électrodes (128) et des portions diélectriques (122) forment ensemble la surface continue sensiblement plane (130).

14. Procédé selon l'une des revendications 11 à 13, comportant en outre, après l'étape de planarisation du matériau électriquement conducteur (158), la réalisation d'une structure de connexion (132) des diodes (102) sur les faces supérieures des premières électrodes (114), des deuxièmes électrodes (128) et des portions diélectriques (122), la structure de connexion (132) comportant au moins des éléments électriquement conducteurs (136, 138, 150) reliés électriquement aux premières (114) et/ou aux deuxièmes (128) électrodes des diodes (102) et isolés électriquement les uns des autres par des éléments diélectriques (134).

## Patentansprüche

1. Elektronische Vorrichtung (100) mit zumindest zwei Dioden (102) mit Mesa-Struktur, wobei jede Diode (102) zumindest enthält:
- einen ersten (108) und einen zweiten (110) dotierten Halbleiterabschnitt, die einen p-n-Übergang bilden und derart ausgeführt sind, dass ein erster Teil (117) des zweiten dotierten Halbleiterabschnitts (110), der zwischen einem zweiten Teil (119) des zweiten dotierten Halbleiterabschnitts (110) und dem ersten dotierten Halbleiterabschnitt (108) angeordnet ist, auf einer einzigen Seite der Mesa-Struktur einen Absatz bezüglich des zweiten Teils (119) des zweiten dotierten Halbleiterabschnitts (110) bildet,
- eine erste Elektrode (114), die elektrisch mit dem ersten dotierten Halbleiterabschnitt (108) verbunden ist, und eine zweie Elektrode (128), die elektrisch mit dem zweiten dotierten Halbleiterabschnitt (110) im Bereich einer Oberseite (126) des zweiten Teils (119) des zweiten dotierten Halbleiterabschnitts (110) verbunden ist,
- dielektrische Abschnitte (122), die Seitenflanken des ersten dotierten Halbleiterabschnitts (108), des zweiten dotierten Halbleiterabschnitts (110) und der ersten Elektrode (114) überdecken und derart ausgeführt sind, dass im Bereich der Seitenflächen der Mesa-Struktur, die nicht den Absatz bilden, die dielektrischen Abschnitte (122) entlang der gesamten Höhe der Mesa-Struktur durchgehend verlaufen,
wobei die Oberseiten der ersten Elektrode (114), der zweiten Elektrode (128) und der dielektrischen Abschnitte (122) eine im Wesentlichen ebene, durchgehende Fläche (130) bilden,
und wobei:
- die Dioden (102) elektrisch in Reihe verbunden sind, derart, dass die erste Elektrode (114) einer der beiden Dioden (102) elektrisch mit der zweiten Elektrode (128) der anderen der beiden Dioden (102) verbunden ist,
- die zweite Elektrode (128) der anderen der beiden Dioden (102) mit einem der dielektrischen Abschnitte (122) der einen der beiden Dioden (102) in Kontakt steht, der eine der Seitenflächen der Mesa-Struktur überdeckt, die nicht den Absatz bilden.

2. Elektronische Vorrichtung (100) nach Anspruch 1, wobei die erste Elektrode (114), der erste dotierte Halbleiterabschnitt (108), der erste Teil (117) des zweiten dotierten Halbleiterabschnitts (110) und der zweite Teil (119) des zweiten dotierten Halbleiterabschnitts (110) einer jeden der Dioden (102) jeweils einen rechteckförmigen Querschnitt in einer Ebene parallel zu einer Schnittstelle zwischen dem ersten (117) und dem zweiten (119) Teil des zweiten dotierten Halbleiterabschnitts (110) haben.

3. Elektronische Vorrichtung (100) nach Anspruch 2, wobei für jede der Dioden (102) eine Abmessung einer Seite des Querschnitts des zweiten Teils (119) des zweiten dotierten Halbleiterabschnitts (110) größer ist als die einer Seite des Querschnitts des ersten Teils (117) des zweiten dotierten Halbleiterabschnitts (110), die parallel zur genannten Seite des Querschnitts des zweiten Teils (119) des zweiten dotierten Halbleiterabschnitts (110) ist.

4. Elektronische Vorrichtung (100) nach einem der vorangehenden Ansprüche, wobei jede der Dioden (102) eine Photodiode oder eine LED ist.

5. Elektronische Vorrichtung (100) nach Anspruch 4, wobei die Photodiode (102) zumindest einen intrinsischen Halbleiterabschnitt (106) aufweist, der zwischen dem ersten (108) und dem zweiten (110) dotierten Halbleiterabschnitt angeordnet und derart ausgeführt ist, dass Seitenflanken des intrinsischen Halbleiterabschnitts mit den dielektrischen Abschnitten (112) überdeckt sind, oder wobei die LED (102) zumindest einen emittierenden Wirkbereich (106) mit zumindest einem Quantentopf aufweist, der zwischen dem ersten (108) und dem zweiten (110) dotierten Halbleiterabschnitt angeordnet und derart ausgeführt ist, dass die Seitenflanken des emittierenden Wirkbereichs (106) mit dielektrischen Abschnitten (122) überdeckt sind.

6. Elektronische Vorrichtung (100) nach einem der vorangehenden Ansprüche, wobei die Oberseiten der ersten Elektroden (114), der zweiten Elektroden (128) und der dielektrischen Abschnitte (122) der Dioden (102) zusammen die im Wesentlichen ebene, durchgehende Fläche (130) bilden.

7. Elektronische Vorrichtung (100) nach einem der vorangehenden Ansprüche, ferner enthaltend eine Verbindungsstruktur (132) zum Verbinden der Dioden (102), die an den Oberseiten der ersten Elektroden (114), der zweiten Elektroden (128) und der dielektrischen Abschnitte (122) angeordnet ist, wobei die Verbindungsstruktur (132) zumindest elektrisch leitfähige Elemente (136, 138, 150) aufweist, die elektrisch mit den ersten (114) und/oder zweiten (128) Elektroden der Dioden (102) verbunden und durch dielektrische Elemente (134) elektrisch voneinander getrennt sind.

8. Elektronische Vorrichtung (100) nach Anspruch 7, wobei eine Oberseite (140) der Verbindungsstruktur (132) eine durchgehende, ebene Fläche bildet.

9. Elektronische Vorrichtung (100) nach einem der Ansprüche 7 oder 8, wobei zumindest ein Teil der Dioden (102) über zumindest einen Teil der elektrisch leitfähigen Elemente (150) der Verbindungsstruktur (132) elektrisch in Reihe miteinander verbunden sind, wobei jedes der elektrisch leitfähigen Elemente (150) eine zweite Elektrode (128) einer der Dioden (102) mit einer ersten Elektrode (114) einer weiteren der Dioden (102) elektrisch verbindet.

10. Elektronische Vorrichtung (100) nach Anspruch 7 oder 8, wobei jedes elektrisch leitfähige Element (136, 138) der Verbindungsstruktur (132) einen Verbindungszapfen bildet, der elektrisch mir einer einzigen Elektrode (114, 128) einer der Dioden (102) verbunden ist, wobei die elektronische Vorrichtung (100) ferner ein Substrat (142) aufweist, das auf die Verbindungsstruktur (132) hybridisiert ist und Mittel enthält, die dazu geeignet sind, elektrische Verbindungen (148) zwischen den elektrisch leitfähigen Elementen (136, 138) der Verbindungsstruktur (132) zu bilden.

11. Verfahren zum Herstellen einer elektronischen Vorrichtung (100) mit zumindest zwei Dioden (102) mit Mesa-Struktur, umfassend zumindest die nachfolgenden Schritte:
- Ausbilden einer Stapelung von Schichten, die zumindest eine erste dotierte Halbleiterschicht (108) aufweist, die zwischen einer zweiten dotierten Halbleiterschicht (110) und einer elektrisch leitfähigen Schicht (114) angeordnet ist,
- Ätzen der Stapelung von Schichten, wobei für jede Diode (102) ein erster (108) und ein zweiter (100) dotierter Halbleiterabschnitt gebildet wird, die einen p-n-Übergang bilden, wobei der zweite dotierte Halbleiterabschnitt (110) einen ersten Teil (117) aufweist, der zwischen einem zweiten Teil (119) des zweiten dotierten Halbleiterabschnitts (110) und dem ersten dotierten Halbleiterabschnitt (108) angeordnet ist und auf einer einzigen Seite der Mesa-Struktur einen Absatz bezüglich des zweiten Teils (119) des zweiten dotierten Halbleiterabschnitts (110) bildet, und wobei eine erste Elektrode (114) gebildet wird, die elektrisch mit dem ersten dotierten Halbleiterabschnitt (108) verbunden ist,
- Ausbilden von dielektrischen Abschnitten (122), die Seitenflanken des ersten dotierten Halbleiterabschnitts (108), des zweiten dotierten Halbleiterabschnitts (110) und der ersten Elektrode (114) einer jeden Diode (102) überdecken und derart ausgeführt sind, dass im Bereich der Seitenflächen der Mesa-Struktur einer jeden Diode (102), die nicht den Absatz bilden, die dielektrischen Abschnitte (122) entlang der gesamten Höhe der Mesa-Struktur durchgehend verlaufen,
- Aufbringen von zumindest einem elektrisch leitfähigen Material (158) zwischen den Mesa-Strukturen der Dioden (102) und in Kontakt mit einer Oberseite (126) des zweiten Teils (119) des zweiten dotierten Halbleiterabschnitts (110) einer jeden Diode (102),
- Planarisieren des elektrisch leitfähigen Materials (158) mit Anhalten an der ersten Elektrode (114), wodurch für jede Diode (102) eine zweite Elektrode (128) gebildet wird, die elektrisch mit dem zweiten dotierten Hableiterabschnitt (110) verbunden und derart ausgeführt ist, dass Oberseiten der ersten Elektrode (114), der zweiten Elektrode (128) und der dielektrischen Abschnitte (122) eine im Wesentlichen ebene, durchgehende Fläche (130) bilden,
- Herstellen einer elektrischen Verbindung, die die Dioden (102) elektrisch in Reihe derart verbindet, dass die erste Elektrode (114) einer der beiden Dioden (102) elektrisch mit der zweiten Elektrode (1298) der anderen der beiden Dioden (102) verbunden wird,
- und wobei die zweite Elektrode (128) der anderen der beiden Dioden (102) mit einem der dielektrischen Abschnitte (122) der einen der beiden Dioden (102) in Kontakt ist, die eine der Seiten der Mesa-Struktur überdecken, die nicht den Absatz bilden.

12. Verfahren nach Anspruch 11, wobei das Ätzen der Stapelung von Schichten mit einer Maske (156) erfolgt, die an der Stapelung von Schichten angeordnet ist und dem ersten Teil (117) des zweiten dotierten Halbleiterabschnitts (110) gegenüberliegend einen ersten Teil (157) aufweist, der in der Dicke größer ist als ein zweiter Teil (159) der Maske (156), der der Oberseite (126) des zweiten Teils (119) des zweiten dotierten Halbleiterabschnitts (110) gegenüberliegend angeordnet ist, der dazu bestimmt ist, mit der zweiten Elektrode (128) in Kontakt zu gelangen.

13. Verfahren nach einem der Ansprüche 11 oder 12, wobei durch die erfolgten Schritte die Dioden (102) mit Mesa-Struktur gebildet werden, deren Oberseiten der ersten Elektroden (114), der zweiten Elektroden (128) und der dielektrischen Abschnitte (122) zusammen die im Wesentlichen ebene, durchgehende Fläche (130) bilden.

14. Verfahren nach einem der Ansprüche 11 bis 13, ferner umfassend nach dem Schritt der Planarisierung des elektrisch leitfähigen Materials (158) das Ausbilden einer Verbindungsstruktur (132) zum Verbinden der Dioden (102) an den Oberseiten der ersten Elektroden (114), der zweiten Elektroden (128) und der dielektrischen Abschnitte (122), wobei die Verbindungsstruktur (132) zumindest elektrisch leitfähige Elemente (136, 138, 150) aufweist, die elektrisch mit den ersten (114) und/oder zweiten (128) Elektroden der Dioden (102) verbunden und durch dielektrische Elemente (134) elektrisch voneinander getrennt sind.

## Claims

1. Electronic device (100) comprising at least two mesa structure diodes (102), each diode (102) comprising at least:
- a first (108) and a second (110) doped semiconductor portion forming a p-n junction, such that a first part (117) of the second doped semiconductor portion (110) located between a second part (119) of the second doped semiconductor portion (110) and the first doped semiconductor portion (108) forms, on a single side of the mesa structure, an offset from the second part (119) of the second doped semiconductor portion (110),
- a first electrode (114) electrically connected to the first doped semiconductor portion (108), and a second electrode (128) electrically connected to the second doped semiconductor portion (110) at an upper face (126) of the second part (119) of the second doped semiconductor portion (110),
- dielectric portions (122) covering the side faces of the first doped semiconductor portion (108), the second doped semiconductor portion (110) and the first electrode (114) such that dielectric portions (122) at the sides of the mesa structure that do not form an offset are continuous along the entire height of the mesa structure,
in which the upper faces of the first electrode (114), the second electrode (128) and the dielectric portions (122) form an approximately plane continuous surface (130),
and in which:
- the diodes (102) are electrically connected in series such that the first electrode (114) of one of the two diodes (102) is electrically connected to the second electrode (128) of the other of the two diodes (102),
- the second electrode (128) of said other of the two diodes (102) is in contact with one of the dielectric portions (122) of said one of the two diodes (102) covering one of the sides of the mesa structure that does not form the offset.

2. Electronic device (100) according to claim 1, in which the first electrode (114), the first doped semiconductor portion (108), the first part (117) of the second doped semiconductor portion (110) and the second part (119) of the second doped semiconductor portion (110) of each diode (102) each have a section in a plane parallel to an interface between the first (117) and the second (119) parts of the second doped semiconductor portion (110), with a rectangular shape.

3. Electronic device (100) according to claim 2, in which for each diode (102), a dimension of one side of the section of the second part (119) of the second doped semiconductor portion (110) is greater than a dimension of the section of the first part (117) of the second doped semiconductor portion (110) parallel to said side of the section of the second part (119) of the second doped semiconductor portion (110).

4. Electronic device (100) according to one of previous claims, in which each diode (102) is a photodiode or a LED.

5. Electronic device (100) according to claim 4, in which the photodiode (102) comprises at least one portion of intrinsic semiconductor (106) arranged between the first (108) and second (110) doped semiconductor portions such that the side faces of the intrinsic semiconductor portion are covered by the dielectric portions (112), or in which the LED (102) comprises at least one active emission zone (106) with at least one quantum well arranged between the first (108) and the second (110) doped semiconductor portions and such that the side faces of the active emission zone (106) are covered by the dielectric portions (122).

6. Electronic device (100) according to one of previous claims, in which the upper faces of the first electrodes (114), the second electrodes (128) and the dielectric portions (122) of said diodes (102) together form the approximately plane continuous surface.

7. Electronic device (100) according to one of previous claims, also comprising a diode (102) connection structure (132) located on the upper faces of the first electrodes (114), the second electrodes (128) and the dielectric portions (122), the connection structure (132) comprising at least electrically conducting elements (136, 138, 150) electrically connected to the first (114) and/or second (128) electrodes of the diodes (102) and electrically insulated from each other by dielectric elements (134).

8. Electronic device (100) according to claim 7, in which an upper face (140) of the connection structure (132) forms a plane continuous surface.

9. Electronic device (100) according to one of claims 7 or 8, in which at least some of the diodes (102) are electrically connected to each other in series by at least some of the electrically conducting elements (150) of the connection structure (132), each of said electrically conducting elements (150) electrically connecting a second electrode (128) of one of said diodes (102) to a first electrode (114) of the other of said diodes (102).

10. Electronic device (100) according to one of claims 7 or 8, in which each electrically conducting element (136, 138) in the connection structure (132) forms a connection pad electrically connected to a single electrode (114, 128) of one of the diodes (102), the electronic device (100) also comprising a substrate (142) hybridized onto the connection structure (132) and comprising means capable of forming electrical connections (148) between the electrically conducting elements (136, 138) of the connection structure (132).

11. Method of manufacturing an electronic device (100) comprising at least two mesa structure diodes (102), comprising at least the following steps:
- make a stack of layers comprising at least one first doped semiconductor layer (108) arranged between a second layer of doped semiconductor (110) and an electrically conducting layer (114),
- etch the stack of layers, for each diode (102) making a first (108) and a second (110) doped semiconductor portions forming a p-n junction, the second doped semiconductor portion (110) comprising a first part (117) located between a second part (119) of the second doped semiconductor portion (110) and the first doped semiconductor portion (108) and on a single side of the mesa structure forming an offset from the second part (119) of the second doped semiconductor portion (110), and making a first electrode (114) electrically connected to the first doped semiconductor portion (108),
- make dielectric portions (122) covering the side faces of the first doped semiconductor portion (108), the second doped semiconductor portion (110) and the first electrode (114) of each diode (102) and such that the dielectric portions (122) at the sides of the mesa structure of each diode (102) that do not form an offset are continuous along the entire height of the mesa structure,
- deposit of at least one electrically conducting material (158) between the mesa structure of diodes (102) and in contact with an upper face (126) of the second part (119) of the second doped semiconductor portion (110) of each diode (102),
- planarization of the electrically conducting material (158) stopping on the first electrode (114), for each diode (102) forming a second electrode (128) electrically connected to the second doped semiconductor portion (110) and such that the upperfaces of the first electrode (114), the second electrode (128) and the dielectric portions (122) form an approximately plane continuous surface (130),
- make an electrical connection electrically connecting diodes (102) in series such that the first electrode (114) of one of the two diodes (102) is electrically connected to the second electrode (128) of the other of the two diodes (102),
and in which the second electrode (128) of said other of the two diodes (102) is in contact with one of the dielectric portions (122) of said one of the two diodes (102) covering one of the sides of the mesa structure not forming the offset.

12. Method according to claim 11, in which the stack of layers is etched using a stencil (156) placed on the stack of layers and comprising a first part (157) with a thickness greater than the thickness of a second part (159) of the stencil (156) arranged facing the upper face (126) of the second part (119) of the second doped semiconductor portion (110) intended to be in contact with the second electrode (128), facing the first part (117) of the second doped semiconductor portion (110).

13. Method according to one of claims 11 or 12, in which the steps used form the mesa structure diodes (102) for which the upper faces of first electrodes (114), second electrodes (128) and dielectric portions (122) together form the approximately plane continuous surface (130).

14. Method according to one of claims 11 to 13, also including a step, after the planarization step of the electrically conducting material (158), to make a diode (102) connection structure (132) on the upper faces of the first electrodes (114), the second electrodes (128) and the dielectric portions (122), the connection structure (132) comprising at least electrically conducting elements (136, 138, 150) electrically connected to the first (114) and/or second (128) electrodes of the diodes (102) and electrically insulated from each other by dielectric elements (134).
